# EUROPEAN PATENT APPLICATION

(11) **EP 1 983 810 A2**
(43) Date of publication of application: **22.10.2008**
(21) Application number: 08153927.2
(22) Date of filing: 01.04.2008
(51) Int. Cl.: H05K 3/34

(54) **Method for mounting leaded component to substrate**

(30) Priority: 20.04.2007 US 788702
(71) Applicant: Delphi Technologies, Inc., Troy, Michigan 48007 (US)
(72) Inventor: Stillabower, Morris D., Tipton, IN 46072-9111 (US); Venkatesan, Sathur, Lafayette, IN 47905 (US); Wittmer, Philip W., Greentown, IN 46936 (US)
(74) Representative: Denton, Michael John

(57) **Abstract**

A process for stabilizing an electrical component having a body and electrical leads projecting from the body and received in through-holes defined in a substrate, while avoiding disadvantages associated with dispensing a hot-melt adhesive during assembly of an electrical package, involves steps of providing a circuit substrate having through-holes for receiving the leads of a leaded electrical component, providing an electrical component having a body and leads extending from the body, positioning a preformed hot-melt adhesive on the circuit substrate or on the electrical component, positioning the electrical component on the circuit substrate so that the leads extend into the through-holes and so that the preformed hot-melt adhesive is positioned between and fills the gap between the body of the electrical component and the substrate, and activating and solidifying the hot-melt adhesive to securely adhere the body of the electrical component to the substrate.

## Description

### Technical Field

This invention relates generally to the field of assembling electrical packages by mounting electrical components on a substrate having electrically conductive traces that together with the components define electrical circuitry, and more particularly to improved mounting of an electrical component having a body and electrical leads projecting from the body and extending into through-holes defined in the substrate.

### Background of the Invention

Electrical packages comprising electrical components that have a body and electrical leads extending from the body and into through-holes defined in the substrate typically require auxiliary securement structure to stabilize the component when the package is subject to excessive vibrations or other sources of acceleration that exert forces on the component which are transferred to the solder connections through the electrical leads of the component. The forces impose stress on the solder connection unless the component is otherwise stabilized or restrained. Repeated stress on the solder connection can cause fatigue failure (cracking) of the solder connection and the electrical package.

Methods for stabilizing an electrical component having projecting leads that are received in through-holes of a substrate have included dispensing a hot-melt adhesive onto the substrate and/or onto the component during the assembly process to adhere the body of the electrical component to the substrate, securing the component to the substrate with wire clamps, or securing the component to the substrate with auxiliary fasteners such as screws. All of these known techniques have disadvantages. Clamps are themselves subject to fatigue failure, complicate the assembly process, adding excessive cost to the completed product, and cannot be easily configured for use with differently shaped and/or sized electrical components. Similarly, the use of fasteners adds significantly to the cost of the assembled product, and requires that the electrical component be designed with an integral mounting bracket to accommodate the fastener.

The use of adhesives for securely mounting an electrical component to a substrate is typically a more effective and economical way of stabilizing a component against damage due to vibration or other acceleration induced forces as compared with clamps and/or fasteners. Unfortunately, the use of apparatus for dispensing a hot-melt adhesive during the assembly process is undesirable for several reasons. First, the apparatus needed for dispensing a hot-melt adhesive can require a substantial amount of floor space in the assembly area. This can be particularly undesirable when the assembly requires very few components having projecting leads received in through-holes of the substrate. Secondly, it is extremely difficult to precisely control the amount of hot-melt adhesive being dispensed onto the substrate and/or component. This can lead to waste and/or inadequate securement of the component to the substrate. It is also difficult to precisely control the location at which the hot-melt adhesive is dispensed. This can also result in waste and/or inadequate securement of the component to the substrate. Dispensing of hot-melt adhesives in an assembly process also tends to be a production rate limiting step. Finally, difficulties associated with precisely dispensing a hot-melt adhesive can lead to adhesive being deposited at locations where it is undesirable and/or detrimental to the assembled product.

### Summary of the Invention

The invention achieves the advantages of employing a hot-melt adhesive for stabilizing an electrical component having a body and electrical leads projecting from the body and received in through-holes defined in a substrate, while avoiding the disadvantages associated with dispensing a hot-melt adhesive during assembly of an electrical package.

The advantages of the invention are achieved by utilizing a process for stabilizing and/or securely restraining an electrical component having leads projecting from a body of the component and received in through-holes defined in a substrate by employing a preformed mass of a hot-melt adhesive which is disposed between the substrate and the body of the component. The preformed mass of hot-melt adhesive may be deposited on the substrate before the electrical component is positioned on the substrate, or the preformed mass of hot-melt adhesive may be placed on the electrical component to form a sub-assembly that is positioned on the substrate.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a perspective view of an electrical component having attached thereto and being circumscribed by a preformed mass of hot-melt adhesive to facilitate securement of the electrical component to a substrate in accordance with the invention.
FIG. 2 is an elevational view of the component of FIG. 1 mounted to a circuit board.
FIG. 3 is an elevational view of an alternative embodiment in which a cylindrical electrical component is mounted vertically with respect to a substrate employing a preformed hot-melt adhesive in accordance with the invention.
FIG. 4 is a perspective view of the hot-melt preformed mass used for securing a component to a substrate as shown in FIG. 3.
FIG. 5 is an elevational view of a cylindrical electrical component mounted horizontally to a substrate employing a saddle-shaped preformed mass of hot-melt adhesive in accordance with the invention.
FIG. 6 is a perspective view of the preformed mass of hot-melt adhesive used for securing an electrical component to a substrate as shown in FIG. 5.

### Description of the Preferred Embodiments

The invention provides a process for securely attaching and stabilizing a leaded electrical component mounted to a substrate against vibration and other forces applied to the component leads by acceleration. The process involves using a preformed hot-melt adhesive that is positioned between and fills the gap between the body of the electrical component and the substrate.

The expression "leaded electrical component" as used herein refers to an electrical component such as an inductor, transformer, electrolytic can capacitor, battery, etc., having a body and at least two electrical leads that extend outwardly away from the body of the electrical component, with the distal ends of the leads (i.e., the ends furthest from the body of the electrical component) received in through-holes defined in a substrate.

The substrate can be generally any article to which the leaded electrical component is mounted, but is generally a circuit board or wiring board defining electrically conductive traces or pathways that together with components mounted on the substrate define electrical circuitry.

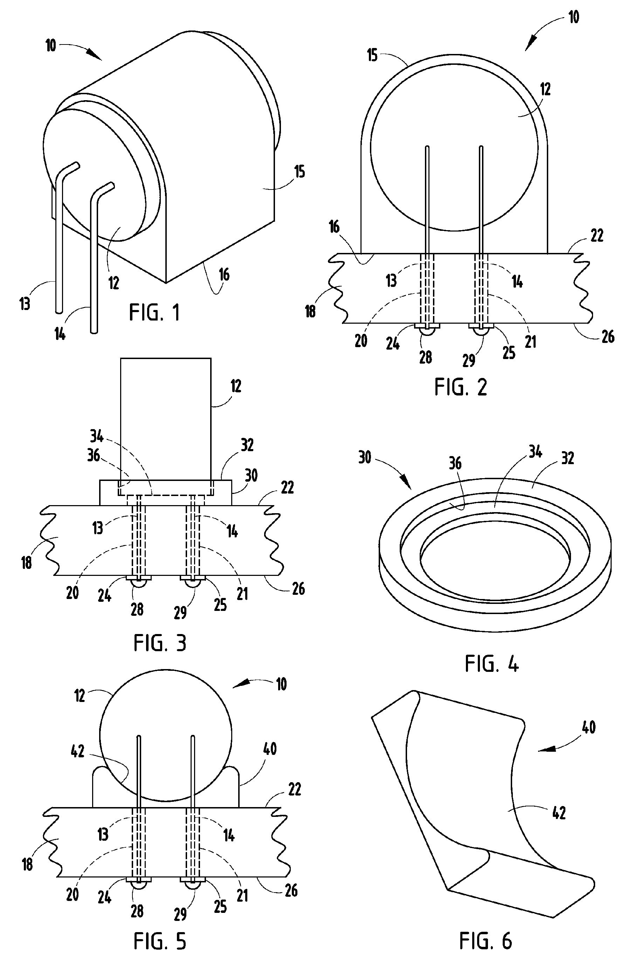

Shown in FIG. 1 is an electrical component 10 having a body 12, and electrical leads 13, 14 projecting outwardly away from body 12. Electrical component 10 is provided with a preshaped or preformed hot-melt adhesive 15 that in the illustrated embodiment of FIG. 1 circumscribes electrical component 10, and has a substantially flat base 16 which is adhered to a substrate to securely fasten electrical component 10 to a substrate and stabilize electrical component 10 against vibration and/or other forces resulting from acceleration. As shown in FIG. 2, electrical component 10 is positioned on substrate 18 with electrical leads 13, 14 passing through holes 20, 21 and with base 16 abutting an upper surface 22 of substrate 18. Through-holes 20, 21 also extend through contact pads 24, 25 on the bottom surface 26 of substrate 18. The distal ends of electrical leads 13, 14 are electrically and mechanically connected to contact pads 24, 25 by solder beads 28, 29, which may be created using a wave-soldering technique.

During the assembly process, preform 16 is heated to a temperature above the softening or melting temperature of the hot-melt adhesive of which preform 16 is comprised. Heating occurs at a temperature and for a time sufficient to cause wetting of the upper surface 22 of substrate 18 by the molten hot-melt adhesive and subsequent adherence between the hot-melt adhesive preform 16 and substrate 18, and between the hot-melt adhesive preform 16 and electrical component 10 upon cooling to a temperature below the melting or softening temperature of the hot-melt adhesive. Soldering and activation (softening or melting) of the hot-melt adhesive preform may be done sequentially or concurrently, with soldering occurring either before or after establishment of adherence between the preform 16 and substrate 18.

FIG. 3 shows an alternative embodiment in which a ring-shaped hot-melt preform 30 is used for securing a cylindrical-shaped electrical component 10 to a substrate 18 in a vertical orientation (i.e., wherein the cylindrical axis of the electrical component is orthogonal to the upper surface of substrate 18). As in the previous embodiment, electrical leads 13, 14 projecting from electrical component 10 extend through holes 20, 21 defined through substrate 18, with the distal ends of leads 13, 14 soldered to contact pads 24, 25 by solder beads 28, 29. As shown in FIG. 4, ring-shaped hot-melt preform 30 includes an outer rim 32 and a recessed inner rim 34 on which component 10 is seated. A circumferential vertical inner wall 36 engages a lower portion of the outer cylindrical wall of component 10 and is adhered thereto upon activation and subsequent re-solidification of hot-melt preform 30. Similarly, upon activation (by heating) and subsequent cooling and re-solidification of hot-melt preform 30, the upper surface of inner rim 34 is bonded to a bottom surface of electrical component 10. The thicknesses and other dimensions of outer rim 32 and inner rim 34 can be varied as necessary or desired to accommodate different size components and/or to provide a higher degree of stabilization if needed. Further, other shapes and variable thicknesses may be used for accommodating electrical components having a different shape.

Shown in FIGs. 5 and 6 is a saddle-shaped hot-melt preform 40 having variable thickness to accommodate horizontal mounting of a cylindrical electrical component 10 on a substrate 18 (i.e., mounting of the component 10 with the cylindrical access parallel and spaced away from upper surface 22 of substrate 18. Securement and adherence of electrical component 10 is achieved between the upper cylindrical surface 42 of preform 40 and a cylindrical surface of electrical component 10. As with the other embodiments, electrical leads 13, 14 extend through holes drilled or otherwise provided through substrate 18, with distal ends of leads 13, 14 soldered to contact pads 24, 25 on bottom surface 26 of substrate 18 by solder beads 28, 29.

In any of the illustrated embodiments, hot-melt preforms 10, 30 and 40 may be preadhered to electrical component 10 before the preforms are adhered to substrate 18. Alternatively, hot-melt preforms may be first positioned on substrate 18, with component 10 being thereafter placed on the preform before activation (softening and/or melting) and subsequent re-solidification.

While the various embodiments of the invention have generally been described with respect to the use of preforms comprising a thermoplastic hot-melt adhesive, the various embodiments of the invention may alternatively employ a thermosetting hot-melt adhesive. In this case, activation refers to a step in which an irreversible chain reaction is initiated to form a cross-linked polymer network that will not melt or become thermoplastic upon subsequent heating.

Hot-melt adhesives are resin (synthetic polymer) compositions that can be activated (e.g., softened or melted) to develop tackiness and/or bond to a surface, and subsequently solidify to securely retain an electrical component on a substrate.

Suitable thermoplastic hot-melt adhesives are those that will melt and/or soften and wet electrical component and substrate surfaces that it contacts without developing a viscosity that is sufficiently low to cause substantial deformation or flow of the preform. Suitable thermoplastic hot-melt adhesives used for preparing the preforms 16, 30, 40 are comprised of 100% or near 100% solids at temperatures up to about at least 100°C, and have a softening or melting point temperatures in the range from about 120°C to about 190°C, with suitable resin types including polyolefins, polyamides, ethylene-propylene copolymers, styrene-butadiene copolymers, ethylene-propene polymer, polyolefin waxes, ethylene-vinyl acetate copolymers, as well as various mixtures of the listed substances. Suitable thermosetting hot-melt adhesives include moisture-curable reactive urethane compositions.

In order to improve heat dissipation, it may be desirable to utilize a hot-melt adhesive for preforms 16, 30, 40 which comprise a thermally conductive filler (e.g. carbon black, alumina or zinc oxide) in an amount sufficient to provide a thermal conductivity in the range from about 0.5 to about 1.0 w/M-K.

The invention reduces solder cracks on large leaded components which are subject to excessive vibration or other forces induced by acceleration, eliminates the need for hot-melt dispensing apparatus on a production assembly line, and allows precise placement of a hot-melt adhesive in a precise amount, thereby reducing waste and/or component failure. The processes of this invention also allow greater control and repetitiveness, and eliminate the time required to warm-up hot-melt equipment. In addition, the use of preforms in accordance with the invention eliminates hot-melt strings that develop during dispensing of hot-melt adhesives. In general, the preforms of this invention can be custom designed and/or configured to conform to the geometry of generally any leaded component. Further, because the electrical component and the hot-melt adhesive are heated concurrently, the process imparts a reduced level of thermal shock to the electrical component, as compared with direct contact between a hot adhesive and a cold electrical component.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A process for stabilizing a leaded electrical component mounted on a circuit board against vibration and/or other forces induced by acceleration, comprising:
providing a circuit substrate having through-holes for receiving the leads of a leaded electrical component;
providing an electrical component having a body and leads extending from the body;
positioning a preformed hot-melt adhesive on the circuit substrate or on the electrical component;
positioning the electrical component on the circuit substrate so that the leads extend into the through-holes and so that the preformed hot-melt adhesive is positioned between and fills a gap between the body of the electrical component and the substrate; and
activating and solidifying the hot-melt adhesive to securely adhere the body of the electrical component to the substrate.

2. The process of claim 1, wherein the electrical component is a relatively heavy or massive device such as an inductor, transformer, electrolytic can capacitor or battery.

3. The process of claim 1, wherein the hot-melt adhesive is a thermoplastic hot-melt adhesive.

4. The process of claim 3, wherein the thermoplastic hot-melt adhesive comprises a polyolefin.

5. The process of claim 3, wherein the thermoplastic hot-melt adhesive comprises polyolefins, polyamides, ethylene-propylene copolymers, styrene-butadiene copolymers, ethylene-propene polymer, polyolefin waxes, ethylene-vinyl acetate copolymers, as well as various mixtures of the listed substances.

6. The process of claim 3, wherein the thermoplastic hot-melt adhesive has a melting temperature or softening temperature of from about 120°C to about 190°C.

7. The process of claim 1, wherein the hot-melt adhesive is a thermosetting hot-melt adhesive.

8. The process of claim 7, wherein the thermosetting hot-melt adhesive is a moisture-curable urethane composition.

9. The process of claim 1, wherein the preformed hot-melt adhesive comprises a sufficient quantity of a thermally conductive filler to provide the adhesive with a thermal conductivity in the range from about 0.5 to about 1.0 w/M-K.

10. The process of claim 1, wherein the preformed hot-melt adhesive has a variable thickness.

11. The process of claim 1, wherein the preformed hot-melt adhesive is comprised of 100% or near 100% solids at a temperature below 100°C.

12. The process of claim 1, wherein the preformed hot-melt adhesive is saddle-shaped to accommodate horizontal mounting of a cylindrical electrical component.

13. The process of claim 1, wherein the preformed hot-melt adhesive is ring-shaped to accommodate vertical mounting of a cylindrical electrical component.

14. The process of claim 1, wherein the preformed hot-melt adhesive circumscribes the electrical component.

15. An electrical package comprising:
a circuit substrate having through-holes;
an electrical component having a body and leads extending from the body and into the through-holes, distal ends of the electrical leads soldered to electrical contact pads on the substrate; and
a solid material circumscribing the electrical component and adhering the electrical component to the substrate.

16. The electrical package of claim 15, wherein the electrical component is a relatively heavy or massive device such as an inductor, transformer, electrolytic can capacitor or battery.

17. The electrical package of claim 15, wherein the material circumscribing the electrical component and adhering the electrical component to the substrate is a thermoplastic selected from polyolefins, polyamides, ethylene-propylene copolymers, styrene-butadiene copolymers, ethylene-propene polymer, polyolefin waxes, ethylene-vinyl acetate copolymers, as well as various mixtures of the listed substances.

18. The electrical package of claim 15, wherein the material circumscribing the electrical component and adhering the electrical component to the substrate is a thermoset material.

19. The electrical package of claim 15, wherein the material circumscribing the electrical component and adhering the electrical component to the substrate is a resin material filled with a sufficient quantity of a thermally conductive filler to provide the material with a thermal conductivity in the range from about 0.5 to about 1.0 w/M-K.
